Europäisches Patentamt

European Patent Office

Office européen des brevets

(11) Numéro de publication: **0 239 467 B1**

# FASCICULE DE BREVET EUROPEEN

(45) Date de publication de fascicule du brevet: **19.02.92**  (51) Int. Cl.⁵: **H04B  7/005**

(21) Numéro de dépôt: **87400566.3**

(22) Date de dépôt: **13.03.87**

(54) **Dispositif de contrôle de puissance d'émission dans une station émettrice-réceptrice de radiocommunication.**

(30) Priorité: **14.03.86 FR 8603684**

(43) Date de publication de la demande:
**30.09.87 Bulletin  87/40**

(45) Mention de la délivrance du brevet:
**19.02.92 Bulletin  92/08**

(84) Etats contractants désignés:
**DE GB NL**

(56) Documents cités:
**GB-A- 2 132 454**
**US-A- 3 745 464**

(73) Titulaire: **Havel, Christophe**
**6, mail R. Menand**
**F-92130 Issy-les-Moulineaux(FR)**

Titulaire: **Mazziotto, Gérald**
**7, rue Cadix**
**F-75015 Paris(JP)**

(72) Inventeur: **Havel, Christophe**
**6, mail R. Menand**
**F-92130 Issy-les-Moulineaux(FR)**
Inventeur: **Mazziotto, Gérald**
**7, rue Cadix**
**F-75015 Paris(JP)**

(74) Mandataire: **Cabinet Martinet & Lapoux**
**BP 405**
**F-78055 Saint Ouentin en Yvelines**
**Cédex(FR)**

Rank Xerox (UK) Business Services

## Description

La présente invention concerne un dispositif de contrôle de puissance d'émission dans une station émettrice-réceptrice de radiocommunication. La station est notamment une station mobile du genre radiotéléphone à bord d'un véhicule. Pour échanger de l'information, telle que des messages de parole et/ou de données, avec une station fixe de base d'un réseau de radiocommunication opérant suivant un procédé d'accès connu.

Dans les systèmes de radiocommunication avec stations mobiles, l'information échangée entre station fixe et station mobile est transmise bidirectionnellement à travers deux canaux radioélectriques soumis à des fluctuations en grande partie aléatoires. Les fluctuations résultent d'une manière générale, de la jonction de trois facteurs :

- un affaiblissement dû à l'éloignement variable entre la station mobile et la station fixe, influant sur la valeur moyenne de la puissance reçue dans chaque station pour une distance donnée ;
- une variation relativement lente autour de la valeur moyenne de puissance, due aux masques ou zones d'ombre se trouvant sur les trajets radioélectriques ; et
- une fluctuation rapide du signal reçu due aux trajets multiples, appelés phénomène de Rayleigh, et presque totalement imprévisible.

D'une manière générale, pour assurer une puissance minimum au niveau du récepteur de la station fixe, il est nécessaire d'augmenter la puissance nominale émise par la station mobile d'une marge de sécurité pour couvrir les fluctuations précédentes. Afin d'économiser au mieux l'énergie disponible pour l'émission de signaux radioélectriques dans la station mobile, il est connu de contrôler la puissance émise dans la station mobile de manière à obtenir un niveau moyen de réception le plus constant possible dans la station fixe. Le dispositif de contrôle selon l'invention permet de remédier aux deux premiers facteurs d'affaiblissement, et ne prend pas en compte des fluctuations rapides de Rayleigh quasi-imprévisibles.

Actuellement, pour lutter contre les fluctuations de signal reçu, une correction est généralement prévue à la réception de signal. Cette correction consiste en une égalisation automatique sélective en fréquence pour remédier à l'effet dû aux trajets multiples, et en un contrôle automatique du gain d'un amplificateur de réception pour remédier aux variations lentes.

Dans certains systèmes de radiocommunication, chaque station mobile dispose de quelques niveaux de puissance d'émission, et une commutation est effectuée après que la station fixe ait détectée une saturation du niveau de puissance reçu, on au contraire un niveau de puissance trop faible, pour assurer une réception correcte. La station fixe émet un signal de commutation de puissance vers la station mobile à travers un canal radioélectrique de signalisation. Les commutations de puissance sont ainsi effectuées d'une manière totalement discontinue dans la station mobile.

Les systèmes de radiocommunication précités offrent un inconvénient majeur résidant dans le fait que, chaque station mobile en communication avec une station fixe étant à une position variable différente, les conditions de propagation diffèrent de l'une à l'autre position, et e niveau de puissance reçu à la station fixe varie beaucoup suivant la position de la station mobile. Ceci rend la réalisation des moyens de réception dans la station fixe plus complexe.

D'autre part, la station mobile émet, par sécurité, une puissance très souvent bien supérieure à celle nécessaire pour assurer une réception convenable dans la station fixe. Il en découle

d'une part une consommation d'énergie inutile, ce qui peut être critique pour une station mobile dont les ressources en énergie sont par nature très limitées ;

d'autre part l'énergie superflue émise par la station mobile contribue à augmenter le niveau de bruit susceptible de brouiller les communications relatives à d'autres stations mobiles situées dans la cellule de service contenant la station fixe.

Le but de l'invention est de fournir un dispositif pour contrôler, en permanence et de manière autonome, la puissance émise par une station, telle qu'une station mobile, à partir de la puissance qu'elle a reçue, afin d'obtenir un niveau moyen de réception constant dans l'autre station, telle que station fixe, quelle que soit la position de la station mobile à l'intérieur de la cellule de service de la station fixe.

A cette fin, un dispositif de contrôle de puissance d'émission dans une station émettrice-réceptrice de radiocommunication est caractérisé en ce qu'il comprend des moyens pour mesurer une puissance de signal reçue par la station à des instants prédéterminés, des moyens pour estimer à chaque instant prédéterminé une puissance de signal qui sera reçue par la station à un instant prédéterminé suivant, en fonction de la puissance mesurée afin de produire une puissance estimée, et des moyens pour réduire une puissance de signal émise par la station entre les instants successifs en proportion de la puissance estimée.

Vu de la station émettrice-réceptrice, telle que station mobile, le niveau de puissance moyen avec lequel la station fixe reçoit chacun des signaux émis par les stations mobiles avec lesquelles la station fixe dialogue, peut être rendu équivalent. Dans chaque station mobile, le dispositif de contrôle ajuste indépendamment le niveau de puissance d'émission sans autre information de la station fixe que celle que la station mobile déduit de la mesure de la puissance reçue.

Selon d'autres caractéristiques de l'invention, les moyens pour estimer calculent la puissance estimée $\widehat{pr}^*_{t+T}$ qui sera reçue à un instant $t + T$, en fonction de la puissance de signal $pr^*_t$ reçue et mesurée à un instant prédéterminé $t$ et de la puissance estimée $\widehat{pr}^*_t$ de ladite puissance reçue et mesurée $pr^*_t$, selon l'équation suivante :

$$\widehat{pr}^*_{t+T} = \widehat{pr}^*_t + k(pr^*_t - \widehat{pr}^*_t)$$

où $k$ est un facteur inférieur à 1, de préférence sensiblement égal à 0,25 et T désigne un intervalle de temps, de préférence une période inférieure à la seconde, entre deux instants successifs. Les moyens pour réduire comprennent des moyens d'amplification à gain variable pour amplifier un signal à émettre de puissance constante et des moyens pour produire un signal de commande de gain des moyens pour amplifier, le signal de commande de gain en décibels variant suivant une fonction linéaire de la puissance estimée. Le dispositif de contrôle opère ainsi une 9réduction de la puissance émise par rapport à une puissance constante nominale nécessaire pour communiquer en limite de portée dans les plus mauvaises conditions de propagation. Cette réduction de puissance diminue de façon notable l'énergie consommée par la station, telle que station mobile.

D'autres caractéristiques et avantages de l'invention apparaîtront plus clairement à la lecture de la description suivante de plusieurs réalisation préférées de l'invention en référence aux dessins annexés correspondants dans lesquels :

- la Fig.1 est un bloc-diagramme schématique d'un dispositif de contrôle de puissance d'émission dans une station émettrice-réceptrice de radiocommunication ;
- les Figs.2A et 2B montrent des structures numériques et analogiques d'un régulateur de puissance inclus dans le dispositif de contrôle, respectivement ;
- la Fig.3 est un diagramme de mesure de puissances reçue et émise à la station, telle que station mobile ; et
- les Figs.4A et 4B sont des diagrammes de mesure de puissance reçue dans une station, telle que station fixe, en liaison avec la station mobile non équipée et équipée d'un dispositif de contrôle de puissance, respectivement, pour un même parcours de la station mobile.

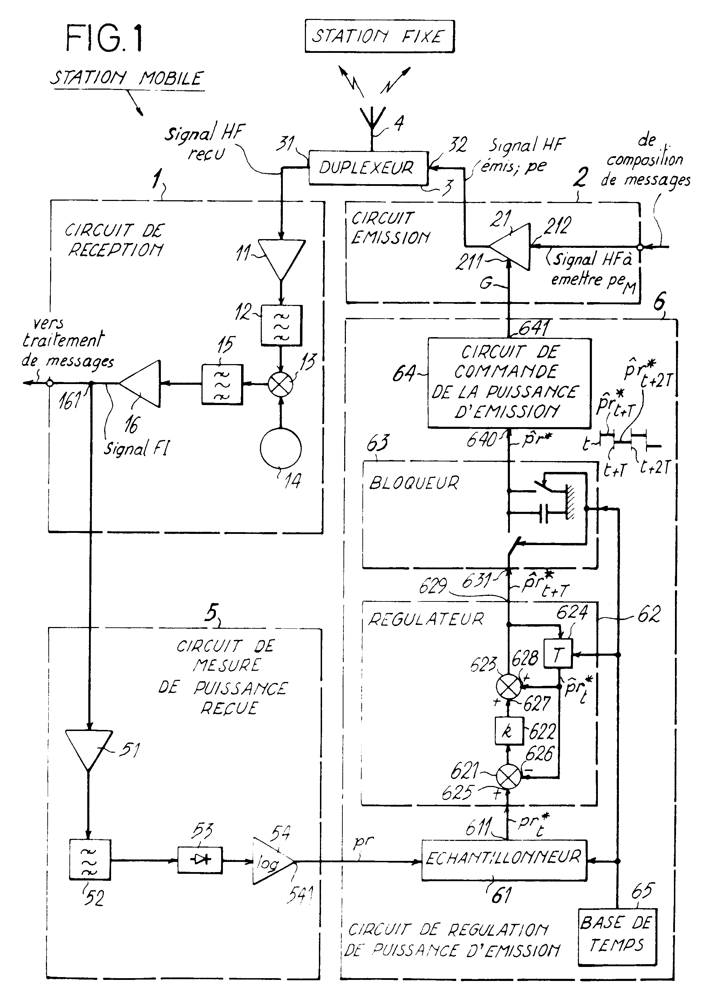

Comme montré à la Fig.1, une station mobile d'un système de radiocommunication comprend classiquement un circuit de réception 1 et un circuit d'émission 2 reliés respectivement à une sortie 31 et une entrée 32 d'un duplexeur hyperfréquence 3 desservant une antenne bidirectionnelle 4.

Le circuit de réception 1 sert à transposer un signal à haute fréquence reçu par l'antenne 4 et le duplexeur 3 et émis, typiquement dans une bande de fréquence étroite voisine de 900 MHz, par une station fixe de base du système de radiocommunication, en un signal à fréquence intermédiaire FI de 70 MHz. Le circuit 1 comprend à partir de la sortie 31 du duplexeur, un préamplificateur à haute fréquence 11, un filtre passe-bande à bande étroite 12, un mélangeur 13 relié à des sorties du filtre 12 et d'un oscillateur local 14, et un filtre passe-bande 15 et un amplificateur 16 filtrant et amplifiant le signal à fréquence intermédiaire FI sortant du mélangeur. Le signal FI délivré par une sortie 161 de l'amplificateur 16 est appliqué d'une part, à l'entrée d'un circuit de mesure de puissance reçue 5, d'autre part, à des moyens connus inclus dans la station mobile pour démoduler le signal FI et traiter des messages convoyés par ce signal et transmis par la station fixe.

Le circuit de mesure 5 ainsi qu'un circuit de régulation de puissance d'émission 6 constituent principalement un dispositif de contrôle de puissance d'émission selon l'invention.

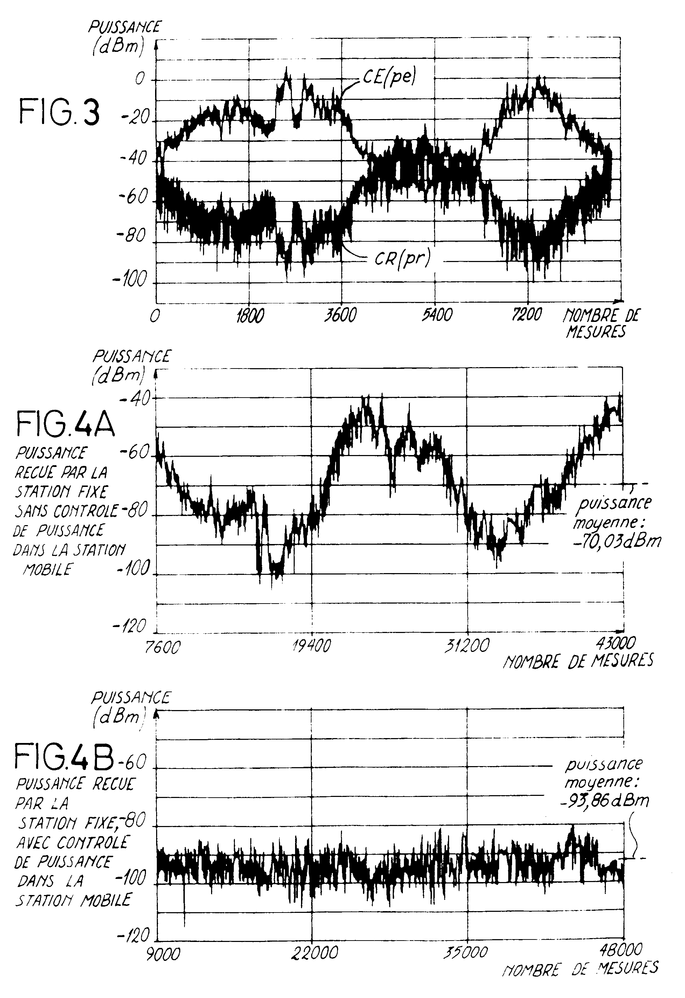

La mesure de la puissance reçue s'effectue sur le signal à fréquence intermédiaire FI obtenu après transposition du signal à haute fréquence reçu. Le circuit de mesure 5 comprend, en série à partir de la sortie 161 de l'amplificateur à fréquence intermédiaire 16, un amplificateur 51 un filtre passe-bande 52, un détecteur de crête 53 détectant l'enveloppe du signal FI, et un amplificateur logarithmique 54. L'amplificateur 54 effectue une transformation en décibel de la puissance instantanée reçue $pr$ correspondant à celle du signal FI. L'allure du signal de puissance reçue $pr$ en sortie 541 de l'amplificateur 54 est montrée par une courbe CR dans la Fig.3 et correspond à des mesures de puissance en cours de déplacement de la station mobile.

Le circuit de régulation 6 comprend en série, à partir de la sortie 541 de l'amplificateur logarithmique 54, un échantillonneur 61, un régulateur de puissance 62, un bloqueur de tension 63, un circuit de commande de puissance d'émission 64 et une base de temps 65. Comme on le verra dans la suite, une sortie 641 du circuit de commande 64 délivre un signal de commande de gain G à une entrée de commande de gain 211 d'un amplificateur de puissance à gain variable 21 inclus dans le circuit d'émission 2 afin de contrôler la puissance d'un signal à haute fréquence à émettre vers la station fixe. Le signal HF à émettre avec une puissance constante $pe_M$ est appliqué à une entrée 212 de l'amplificateur 21 par des moyens connus inclus dans la station mobile pour composer des messages à transmettre vers la station fixe, les moduler à fréquence intermédiaire et les transposer à haute fréquence. Le signal à émettre convenablement amplifié est appliqué par l'amplificateur 21 à l'entrée 32 du duplexeur 3.

La base de temps 65 fournit un signal d'horloge à période T à l'échantillonneur 61, à un circuit ou ligne de retard inclus dans le régulateur 62 et au bloqueur 63. En pratique, la base de temps 65 est commune aux moyens de traitement et de composition de messages déjà cités, et peut comprendre un diviseur de fréquence programmable afin de fournir un signal d'horloge ayant une période T variant en fonction de la vitesse de déplacement de la station mobile ; par exemple, lorsque la station mobile est embarquée dans un véhicule, le diviseur de fréquence est programmé par un capteur de déplacement, tel que tachymètre, ou est remplacé par ce capteur, afin de fournir une impulsion d'horloge en moyenne toutes les 100 millisecondes pour un déplacement moyen de la station mobile ayant une longueur prédéterminée d'environ 1 mètre, soit une vitesse de 10 m/s. Lorsque la période T du signal d'horloge n'est pas programmable, celle-ci est égale ou inférieur à une seconde environ. Ainsi, le signal de puissance reçue pr à la sortie 541 de l'amplificateur logarithmique est échantillonné dans l'échantillonneur 61 ayant une sortie 611 délivrant des échantillons de puissance reçue $pr^*_t$, $pr^*_{t+T}$, $pr^*_{t+2T}$,... à des instants successifs prédéterminés t, t+T, t+2T,... appliqués au régulateur 62.

Le régulateur 62 a pour rôle d'estimer au début t d'une période d'échantillonnage T, une puissance $pr^*_{t+T}$ qui sera reçue et échantillonnée au début t+T de la période suivante en fonction de la puissance $pr^*_t$ reçue et échantillonnée à l'instant t, afin de fournir une puissance estimée $\widehat{pr}^*_{t+T}$ servant à contrôler la puissance d'émission dans l'amplificateur 21 pendant la période d'échantillonnage T. Une étude théorique vérifiée par des mesures a mis en évidence que la prédiction de puissance reçue donnée par l'équation suivante était satisfaisante :

$$\widehat{pr}^*_{t+T} = \widehat{pr}^*_t + k\,(pr^*_t - \widehat{pr}^*_t)$$

où le signe ^ représente la fonction estimation et k un facteur prédéterminé constant inférieur à 1. L'étude théorique complétée par une étude statistique de simulations avec des valeurs des paramètres k et T, principalement en milieu urbain où les effets de zone d'ombre ou masque sont fréquents, a montré que les performances du régulateur sont peu dépendants du coefficient k et qu'il n'est pas nécessaire de l'adapter en permanence aux conditions de déplacement de la station mobile et aux conditions de propagation des ondes radioélectriques. Pour un échantillonnage à période moyenne T = 100 ms et une vitesse moyenne de déplacement de la station mobile de 10 m/s, le coefficient k est choisi égal à 0,25 environ, pour obtenir une puissance de réception pratiquement constante dans la station fixe, comme montré à la Fig.4B. Comparativement à la Fig.4A montrant des résultats de mesure de puissance reçue par la station fixe lorsque la station mobile n'est pas équipée d'un dispositif de contrôle de puissance d'émission selon l'invention, la Fig.4B correspondant à des mesures pour un même parcours de la station mobile met en évidence la constance de la puissance reçue dans la station fixe grâce au dispositif de contrôle. Selon les études précitées, le coefficient k est obtenu à partir de la formule suivante établie à partir d'une mise en forme statistique des conditions de propagation :

$$k = a/(1 + 2\sigma^2_W/(\sigma^2_B + (\sigma^4_B + 4.\sigma^2_B.\sigma^2_W)^{1/2}))$$

où a est un facteur voisin de 1, $\sigma^2_W$ une variance de bruit blanc de l'ordre de 40 représentant des fluctuations rapides dues aux trajets multiples, et $\sigma^2_B$ une variance de bruit blanc de l'ordre de 3,5 dépendant de fluctuations lentes dues aux masques.

Comme montré schématiquement à la Fig.1, l'équation de puissance précitée est obtenue dans le régulateur 62 au moyen d'un circuit soustracteur 621, d'un circuit de multiplication par k 622, d'un circuit additionneur 623 et d'un circuit de retard 624 imposant un retard de T. Le circuit soustracteur 621 reçoit par une entrée directe 625 l'échantillon de puissance reçue $pr^*_t$, et par une entrée inverse 626 l'échantillon de puissance reçue $\widehat{pr}^*_t$ estimé au début t-T de la période d'horloge précédente, et délivre une différence d'échantillons de puissance $pr^*_t - \widehat{pr}^*_t$ à une entrée du circuit 622. Le circuit de multiplication 622 applique un produit k-$(pr^*_t - \widehat{pr}^*_t)$ à une première entrée 627 du circuit additionneur 623 pour être additionné à l'échantillon de puissance $\widehat{pr}^*_t$ afin de délivrer un échantillon de puissance estimé $\widehat{pr}^*_{t+T}$ par une borne de sortie 629. La borne de sortie 629 est reliée à l'entrée 626 du circuit soustracteur et à une seconde entrée 628 du circuit additionneur à travers le circuit de retard 624 délivrant l'échantillon $\widehat{pr}^*_{t+T}$ au début de la période d'échantillonnage suivante correspondant à la réception de l'échantillon suivant $pr^*_{t+T}$. Le circuit de retard 624 mémorise ainsi la puissance estimée $\widehat{pr}^*_{t+T}$ entre les instants successifs t et t+T.

En pratique, le régulateur 62 peut être réalisé sous forme numérique ou sous forme analogique.

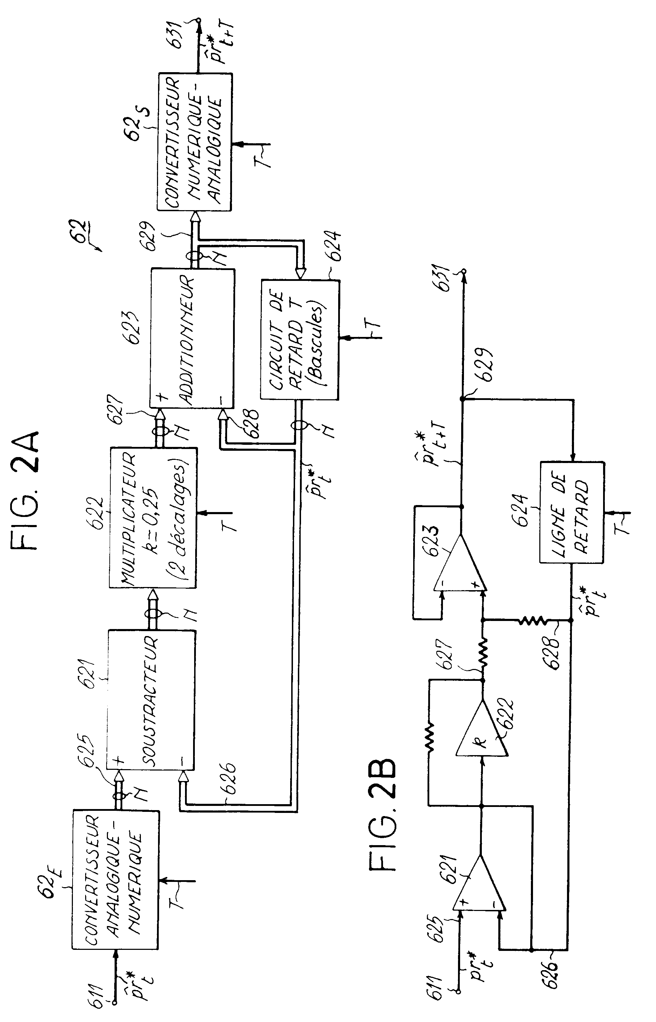

Comme montré à la Fig.2A, le régulateur à structure numérique comprend, en entrée entre les bornes 611 et 625, un convertisseur analogique-numérique $62_E$, et en sortie entre la borne 629 et une borne d'entrée 631 du bloqueur 63, un convertisseur numérique-analogique $62_S$. Les convertisseurs $62_E$ et $62_S$ sont commandés par le signal d'horloge T établi par la base de temps 65. Le convertisseur d'entrée $62_E$ convertit chaque échantillon analogique $pr^*_t$ en un mot d'échantillon ayant un nombre prédéterminé N de bits délivrés en parallèle, tandis que le convertisseur $629_S$ convertit un mot d'échantillon à N bits établis par le circuit additionneur 623 en un échantillon analogique $\widehat{pr}^*_{t+T}$. Les liaisons entre les autres circuits logiques 621 à 624 sont des bus à N fils. Selon la réalisation montrée à la Fig.2A, les circuits 621 et 623 sont des soustracteur et additionneur à portes logiques classiques. Le circuit de multiplication 622 est constitué sur la base d'un registre à décalage avec décalage de deux étages ou pas à chaque période T afin de réaliser une division par $2^2 = 4$ pour k = 0,25. Le circuit de retard est composé de N bascules tampons en parallèle pour mémoriser l'échantillon $\widehat{pr}^*_{t+T}$ entre les instants t et t+T.

Selon la Fig.2B, le régulateur à structure analogique comprend trois amplificateurs opérationnels fonctionnant respectivement en soustracteur, amplificateur de gain k et additionneur pour constituer les circuits 621, 622 et 623. Le circuit 624 est constitué par une ligne de retard imposant un retard T qui peut être programmable par example au moyen d'une série de bascules monostables.

En se référant à nouveau à la Fig.1, le bloqueur 63 comprend d'une manière connue, un condensateur, des moyens pour charger et décharger rapidement le condensateur en début et fin d'une période T par une tension constante et proportionnelle à l'échantillon de puissance estimée $\widehat{pr}^*_{t+T}$ entre les instants t et t+T et appliquée à une entrée 640 du circuit de commande de puissance d'émission 64. Ainsi plus généralement, la tension à l'entrée 640 est une tension discontinue ayant des paliers constants proportionnels aux échantillons de puissance estimée $\widehat{pr}^*_{t+T}$, $\widehat{pr}^*_{t+2T}$,... pendant des intervalles de temps (t, t+T), (t+T, t+2T),...

Si on désigne par $pe_M$ la puissance appliquée à l'entrée 212 du circuit d'émission 2, celle-ci est transmise par le circuit d'amplification 21 avec un gain G en décibels. Dans les conditions les plus défavorables, lorsque la puissance reçue pr est inférieure à un seuil de réception prédéterminé, le gain G est maximum et est égal à $G_{max} = P_O - pe_M$, où $p_O$ désigne la puissance nominale de l'émetteur de la station mobile. La seuil de réception prend en compte la sensibilité $p_m$ du circuit de réception de la station mobile et une marge de puissance MA pour protection contre les évanouissements, typiquement égale à 20 dB. A contrario, lorsque la puissance reçue pr est élevée et tend vers une valeur prédéterminée, le gain G est minimal. La puissance à émettre pe en sortie du circuit d'amplification 21 est montrée graphiquement par la courbe CE dans la Fig.3 et est dans tous les cas :

$$pe = pe_M + G = P_O + p_m + MA - pr$$

Le gain G peut s'écrire sous la forme :

$$G = p_O - pe_M + p_m + MA - pr = G_{max} + p_m + MA - pr,$$

les puissances précitées étant exprimées en dBm et les gains précités en dB.

L'effet de "miroir" entre les courbes CE et CR dans la Fig.3 est caractéristique du régulateur 62 avec un lissage de fluctuations rapides à l'émission.

Le circuit de commande 64 est ainsi destiné à établir le gain G en décibels du circuit d'amplification 21 pendant chaque période d'échantillonnage T en fonction de l'échantillon respectif de puissance reçue estimée $\widehat{pr}^*_{t+T}$. Par exemple, si le contrôle de la puissance émise pe est réalisé dans le circuit d'amplification 21 par commutation d'atténuateurs reliés sélectivement à l'entrée d'un amplificateur, le circuit de commande 64 consiste à piloter ces atténuateurs à partir de la valeur calculée $G_{max}$ - G, soit l'atténuation A = pr ($p_m$ + MA), c'est-à-dire en fonction de la valeur de la puissance reçue estimée à laquelle on soustrait une valeur constante, l'amplificateur ayant un gain $G_{max}$.

Lorsque le régulateur est sous forme de circuits numériques, comme montré à la Fig.2A, la commande de gain peut être réalisée de la manière suivante. Le convertisseur numérique-analogique $62_S$ est supprimé, et une mémoire tampon, faisant office du bloqueur 63, est pilotée par la base de temps 65 et reliée en sortie 629 du régulateur. En sortie de la mémoire tampon, un soustracteur inclus dans le circuit 64 soustrait un nombre constant ($p_m$ + MA) à la puissance reçue estimée $\widehat{pr}^*$ lue périodiquement dans la mémoire pour produire la valeur A. La valeur numérique A est directement utilisée, ou éventuellement après décodage, pour commuter, dans le circuit d'amplification 21, des atténuateurs placés en entrée de l'amplificateur de gain $G_{max}$.

Ainsi il apparaît globalement que la puissance émise pe est indépendante de caractéristiques établies dans la station fixe, ce qui permet de réaliser la régulation de puissance sans recourir à une transmission d'informations particulières de la station fixe vers la station mobile.

Bien que l'invention ait été décrite selon des réalisations préférées, il est à noter que notamment le régulateur en fonctionnement numérique peut être réalisé au moyen d'un microprocesseur dans la mesure où la station mobile contient un tel microprocesseur destiné à d'autres tâches, principalement lorsque les moyens de traitement et de composition de messages de parole et/ou de données sont numériques.

Par ailleurs, le dispositif de contrôle selon l'invention peut être inclus dans la station fixe.

En outre, l'invention est utilisable quel que soit le procédé connu d'accès de radiocommunication utilisé, tel qu'accès multiple à répartition dans le temps (AMRT), ou accès multiple à répartition en fréquence (AMRF) avec ou sans allocation dynamique de canaux temporels ou de fréquence, ou tel qu'accès multiple à répartition dans les codes (AMRC). Il est à noter que, lorsque des stations mobiles sont dotées de dispositifs de contrôle selon l'invention, il n'est plus nécessaire d'adapter les gains des récepteurs dans la station fixe respectivement en fonction des puissances reçues dans les canaux temporels pour un accès AMRT, ou dans les canaux de fréquence pour un accès AMRF, assignés aux stations mobiles, ce qui permet de réduire notablement des brouillages entre canaux adjacents.

## Revendications

1. Dispositif de contrôle de puissance d'émission dans une station émettrice-réceptrice de radiocommunication, caractérisé en ce qu'il comprend des moyens (1, 5, 61) pour mesurer une puissance de signal reçue ($pr^*_t$) par la station à des instants prédéterminés (t, t + T), des moyens (62) pour estimer à chaque instant prédéterminé (t) une puissance de signal ($pr^*_{t+T}$) qui sera reçue par la station à un instant prédéterminé suivant (t + T), en fonction de la puissance mesurée ($pr^*_t$), afin de produire une puissance estimée ($\widehat{pr}^*_{t+T}$), et des moyens (63, 64, 21) pour réduire une puissance de signal (pe) émise par la station entre les instants successifs (t, t + T) en proportion de la puissance estimée ($\widehat{pr}^*_{t+T}$).

2. Dispositif conforme à la revendication 1, caractérisé en ce que les moyens pour estimer (62) calculent la puissance estimée $\widehat{pr}^*_{t+T}$ qui sera reçue à un instant t + T, en fonction de la puissance de signal $pr^*_t$ reçue et mesurée à un instant prédéterminé t et de la puissance estimée $\widehat{pr}^*_t$ de ladite puissance reçue et mesurée $pr^*_t$, selon l'équation suivante :

$$\widehat{pr}^*_{t+T} = \widehat{pr}^*_t + k(pr^*_t - \widehat{pr}^*_t)$$

où k est un facteur inférieur à 1, de préférence sensiblement égal à 0,25, et T désigne un intervalle de temps entre deux instants successifs.

3. Dispositif conforme à la revendication 1 ou 2, caractérisé en ce que les moyens pour estimer (62) comprennent des moyens soustracteurs (621) pour calculer une différence de la puissance de signal reçue ($pr^*_t$) à un instant prédéterminé (t) et la puissance estimée ($\widehat{pr}^*_t$) de cette dernière puissance, des moyens (622) pour multiplier la différence de puissance ($pr^*_t - \widehat{pr}^*_t$) par un facteur prédéterminé (k) inférieur à 1, de préférence sensiblement égal à 0,25, des moyens additionneurs (623) pour additionner le produit ($k(pr^*_t - \widehat{pr}^*_t)$) de la différence de puissance et du coefficient (k) à ladite puissance estimée de cette dernière puissance ($\widehat{pr}^*_t$) afin d'établir la puissance ($\widehat{pr}^*_{t+T}$) estimée de la puissance qui sera reçue à l'instant suivant (t + T), et des moyens (624) pour mémoriser la puissance estimée de l'instant suivant ($\widehat{pr}^*_{t+T}$) pendant un intervalle de temps entre les deux instants (t, t + T) en vue de l'appliquer aux moyens additionneurs et soustracteurs (621, 623) audit instant suivant (t + T).

4. Dispositif conforme à l'une quelconque des revendications 1 à 3, caractérisé en ce que les moyens pour estimer (62) sont sous forme de circuits numériques et comprennent, en entrée, des moyens ($62_E$; Fig. 2A) pour convertir numériquement la puissance de signal reçue ($pr^*_t$) et, en sortie des moyens ($62_S$; Fig. 2A) pour convertir analogiquement la puissance estimée ($\widehat{pr}^*_{t+T}$).

5. Dispositif conforme à l'une quelconque des revendications 1 à 3, caractérisé en ce que les moyens pour estimer (62) sont sous forme de circuits analogiques (621 à 624; Fig.2B).

6. Dispositif conforme à l'une quelconque des revendications 1 à 5, caractérisé en ce que les instants prédéterminés (t, t + T) sont périodiques, de préférence avec une période sensiblement égale ou inférieure à une seconde.

7. Dispositif conforme à l'une quelconque des revendications 1 à 5, caractérisé en ce qu'il comprend des moyens tachymétriques (65) pour fournir des impulsions d'horloge (T) marquant lesdits instants prédéterminés (t, t + T) en réponse à des déplacements de la station ayant une longueur prédéterminée, de préférence sensiblement égale à 1 mètre, lesdits impulsions d'horloge étant appliquées auxdits moyens pour estimer (62) et moyens pour réduire (63, 64, 21).

8. Dispositif conforme à l'une quelconque des revendications 1 à 7, caractérisé en ce que les moyens pour mesurer comprennent des moyens (1) pour transposer un signal à haute fréquence reçu par la station en un signal à fréquence intermédiaire (FI), des moyens (5) pour produire un signal de puissance (pr) proportionnelle à la puissance instantanée du signal à fréquence intermédiaire (FI), et des moyens (61) pour échantillonner le signal de puissance (pr) auxdits instants prédéterminés (t, t + T) en des échantillons de puissance reçue (pr*$_t$) appliqués aux moyens pour estimer (62).

9. Dispositif conforme à la revendication 8, caractérisé en ce que les moyens pour produire un signal de puissance (5) comprennent, en outre, un détecteur de crête (53) suivi d'un amplificateur logarithmique (54).

10. Dispositif conforme à l'une quelconque des revendications 1 à 9, caractérisé en ce que les moyens pour réduire comprennent des moyens d'amplification à gain variable (21) pour amplifier un signal à émettre de puissance constante (pe$_M$) et des moyens (63, 64) pour produire un signal de commande de gain (G) des moyens pour amplifier, le signal de commande de gain en décibel variant suivant une fonction linéaire de la puissance estimée ($\widehat{pr}$*$_{t+T}$).

11. Dispositif conforme à l'une quelconque des revendications 1 à 9, caractérisé en ce que les moyens pour réduire comprennent des moyens (21) pour atténuer un signal à émettre de puissance prédéterminée (pe$_M$) en fonction d'une atténuation variable (A) inférieure à un gain constant (G$_{max}$), des moyens (21) pour amplifier le signal à émettre atténué avec ledit gain constant (G$_{max}$), et des moyens (63, 64) commandant les moyens pour atténuer pour établir l'atténuation variable (A) en fonction de la différence de la puissance estimée ($\widehat{pr}$*$_{t+T}$) et d'une constante prédéterminée (p$_m$ + MA).

12. Dispositif conforme à la revendication 11, caractérisé en ce que la constante prédéterminée est fonction d'une sensibilité de réception (p$_m$) de la station et/ou d'une marge de puissance d'émission pour protection contre les évanouissements (MA).

13. Dispositif conforme à la revendication 11 ou 12, caractérisé en ce que les moyens pour établir l'atténuation variable (63, 64) comprennent des moyens (63) pour produire une tension variant suivant une fonction discontinue à paliers constants de la puissance estimée ($\widehat{pr}$*$_{t+T}$)' chaque palier de tension étant compris entre deux instants prédéterminés successifs (t, t + T) et proportionnel à la puissance estimée ($\widehat{pr}$*$_{t+T}$) au premier desdits deux instants, des moyens (64) pour soustraire de chaque palier de tension une tension proportionnelle à ladite constante prédéterminée (p$_m$ + MA).

## Claims

1. Transmission power control device in a radio communication transmitting and receiving station, characterized in that it comprises means (1, 5, 61) for measuring a received signal power (pr*$_t$) by the station at predetermined instants (t, t + T), means (62) for estimating at each predetermined instant (t) a signal power (pr*$_{t+T}$) which will be received by the station at a next predetermined instant (t + T), as a function of the measured power (Pr*$_t$), thereby producing an estimated power ($\widehat{pr}$*$_{t+T}$), and means (63, 64, 21) for reducing a signal power (pe) transmitted by the station between the successive instants (t, t + T) in proportion to the estimated power ($\widehat{pr}$*$_{t+T}$).

2. Device according to claim 1, characterized in that the estimating means (62) compute the estimated power $\widehat{pr}$*$_{t+T}$ which will be received at an instant t + T, as a function of the signal power pr*$_t$ received and measured at a predetermined instant t and as a function of the estimated power $\widehat{pr}$*$_t$ of said received and measured power pr*$_t$, according to the following equation :

$$\widehat{pr}^*_{t+T} = \widehat{pr}^* + k(pr^*_t - \widehat{pr}^*_t)$$

where k is a factor less than 1, preferrably substantially equal to 0.25, and T denotes a time interval between two successive instants.

3. Device according to claim 1 or 2, characterized in that the estimating means (62) comprise subtractor means (621) for computing a difference between the received signal power (pr*$_t$) at a predetermined instant (t) and the estimated power ($\widehat{pr}$*$_t$) of this last power, means (622) for multiplying the power difference (pr*$_t$ - $\widehat{pr}$*t) by a predetermined factor (k) less than 1, preferably substantially equal to 0.25, adder means (623) for adding the product (k(pr*$_t$ - $\widehat{pr}$*$_t$)) of the power difference and the factor (k) to said estimated power of this last power ($\widehat{pr}$*) in order to establish the power ($\widehat{pr}$*$_{t+T}$) estimated of the power which will be received at the next instant (t + T), and means (624) for memorizing the next instant estimated power ($\widehat{pr}^*_{t+T}$) during a time interval between the two instants (t, t + T), thereby applying it to the adder and subtractor means (621, 623) at said next instant (t + T).

4. Device according to any one of claims 1 to 3, characterized in that the estimating means (62) are in the form of digital circuits and include, on input, means ($62_E$ ; Fig.2A) for converting digitally the received signal power ($pr^*_t$), and, on output, means ($62_S$ ; Fig. 2A) for converting analogically the estimated power ($\widehat{pr}^*_{t+T}$).

5. Device according to any one of claims 1 to 3, characterized in that the estimating means (62) are in the form of analog circuits (621 to 624 ; Fig.2B).

6. Device according to any one of claims 1 to 5, characterized in that the predetermined instants (t, t + T) are periodical, preferrably with a period substantially equal to or less than one second.

7. Device according to any one of claims 1 to 5, characterized in that it comprises tachometric means (65) for supplying clock pulses (T) marking said predetermined instants (t, t + T) in response to movements of the station having a predetermined length, preferrably substantially equal to one meter, said clock pulses being applied to said estimating means (62) and reducing means (63, 64, 21).

8. Device according to any one of claims 1 to 7, characterized in that the measuring means comprise means (1) for transposing a high frequency signal received by the station into an intermediate frequency signal (IF), means (5) for producing a power signal (pr) in proportion to the instantaneous power of the intermediate frequency signal (IF), and means (61) for sampling the power signal (pr) at said predetermined instants (t, t + T) into received power samples ($Pr^*_t$) applied to estimating means (62).

9. Device according to claim 8, characterized in that the power signal producing means (5) further comprise a peak detector (53) followed by a logarithmic amplifier (54).

10. Device according to any one of claims 1 to 9, characterized in that the reducing means comprise variable gain amplification means (21) for amplifying a constant power signal ($pe_M$) to be transmitted and means (63, 64) for producing a signal (G) gain-controlling the amplifying means, the gain controlling signal into decibels varying as a linear function of the estimated power ($\widehat{pr}^*_{t+T}$).

11. Device according to any one of claims 1 to 9, characterized in that the reducing means comprise means (21) for attenuating a predetermined power signal ($pe_M$) to be transmitted as a function of a variable attenuation (A) less than a constant gain ($G_{max}$), means (21) for amplifying the attenuated to-be-transmitted signal with said constant gain ($G_{max}$), and means (63, 64) controlling the attenuating means for establishing the variable attenuation (A) as a function of the difference between the estimated power ($\widehat{pr}^*_{t+T}$) and a predetermined constant ($p_m$ + MA).

12. Device according to claim 11, characterized in that the predetermined constant is a function of a receiving sensitivity ($p_m$) of the station and/or of a transmission power margin for protecting against the fading (MA).

13. Device according to claim 11 or 12, characterized in that the variable attenuation establishing means (63, 64) comprise means (63) for producing a voltage varying according to an intermittent constant increment function of the estimated power ($\widehat{pr}^*_{t+T}$), each voltage increment lying between two successive predetermined instants (t, t + T) and proportional to the estimated power ($\widehat{pr}^*_{t+T}$) at the first of said two instants, means (64) for subtracting from each voltage increment, a voltage proportional to said predetermined constant ($p_m$ + MA).

**Patentansprüche**

1. Einrichtung zur Steuerung der Sendeleistung in einer Funksende-Empfangsanlage, dadurch gekennzeichnet, daß sie Einrichtungen (1, 5, 61) zum Messen einer Leistung des von der Station zu vorgegebenen Zeitpunkten (t, t + T) empfangenen Signals ($pr^*_t$), Einrichtungen (62) zum Schätzen einer Leistung ($pr^*_{t+T}$) eines Signals zu jedem vorgegebenen Zeitpunkt (t), das von der Station zu einem darauffolgenden vorgegebenen Zeitpunkt (t + T) empfangen wird, in Abhängigkeit der gemessenen Leistung ($pr^*_t$), um eine geschätzte Leistung ($\widehat{pr}^*_{t+T}$) zu gewinnen, und Einrichtungen (63, 64, 21) zur Reduktion einer Signalleistung (pe), die von der Station zwischen den aufeinanderfolgenden Zeitpunkten (t, t + T) ausgesandt wird, im Verhältnis der geschätzten Leistung

$(\widehat{pr}^*_{t+T})$, aufweist.

2. Einrichtung nach Anspruch 1, dadurch gekennzeichnet, daß die Schätzeinrichtungen (62) die geschätzte Leistung $\widehat{pr}^*_{t+T}$, die zu einem Zeitpunkt $t + T$ empfangen wird, als Funktion der Signalleistung $pr^*_t$, die zu einem vorgegebenen Zeitpunkt t empfangen und gemessen wurde, und der geschätzten Leistung $pr^*_t$ der empfangenen und gemessenen Leistung $\widehat{pr}^*_t$ nach der folgenden Gleichung:

$$\widehat{pr}^*_{t+T} = \widehat{pr}^*_t + k(pr^*_t - \widehat{pr}^*_t)$$

berechnet, wobei k ein Faktor kleiner als 1 ist, vorzugsweise gleich 0,25, und T ein Zeitintervall zwischen zwei aufeinanderfolgenden Zeitpunkten bedeutet.

3. Einrichtung nach Anspruch 1 oder 2, dadurch gekennzeichnet, daß die Schätzeinrichtungen (62) Subtraktionseinrichtungen (621) zur Berechnung einer Differenz zwischen der empfangenen Signalleistung $(pr^*_t)$ zu einem vorgegebenen Zeitpunkt (t) und der geschätzten Leistung $(\widehat{pr}^*_t)$ dieser letzten Leistung, Einrichtungen (622) zur Multiplikation der Leistungsdifferenz $(pr^*_t - \widehat{pr}^*_t)$ mit einem vorgegebenen Faktor (k) kleiner als 1, vorzugsweise gleich 0,25, Additionseinrichtungen (623) zur Addition des Produkts $(k(pr^*_t - \widehat{pr}^*_t))$ aus der Leistungsdifferenz und dem Koeffizienten (k) zur geschätzten Leistung $(\widehat{pr}^*_t)$ der letzten Leistung, um die geschätzte Leistung $(\widehat{pr}^*_{t+T})$ der Leistung, die zum darauffolgenden Zeitpunkt $(t + T)$ empfangen wird, zu gewinnen, und Einrichtungen (624) zum Speichern der geschätzten Leistung des folgenden Zeitpunkts $(\widehat{pr}^*_{t+T})$ während eines Zeitintervalls zwischen den zwei Zeitpunkten $(t, t + T)$, um diese den Additions- und Subtraktionseinrichtungen (621, 623) zum darauffolgenden Zeitpunkt $(t + T)$ zuzuführen, aufweisen.

4. Einrichtung nach einem der Ansprüche 1 bis 3, dadurch gekennzeichnet, daß die Schätzeinrichtungen (62) als digitale Schaltung ausgebildet sind und am Eingang Einrichtungen ($62_E$; Fig. 2A) zur Digital-Wandlung der Leistung des empfangenen Signals $(pr^*_t)$ und am Ausgang Einrichtungen ($62_S$; Fig. 2A) zur Analogwandlung der geschätzten Leistung $(\widehat{pr}^*_{t+T})$ aufweisen.

5. Einrichtung nach einem der Ansprüche 1 bis 3, dadurch gekennzeichnet, daß die Schätzeinrichtungen (62) als analoge Schaltung ausgebildet sind (621 - 624; Fig. 2B).

6. Einrichtung nach einem der Ansprüche 1 bis 5, dadurch gekennzeichnet, daß die vorgegebenen Zeitpunkte (t, t + T) periodisch sind, vorzugsweise mit einer Periode gleich oder kleiner einer Sekunde.

7. Einrichtung nach einem der Ansprüche 1 bis 5, dadurch gekennzeichnet, daß sie Geschwindigkeitsmeßeinrichtungen (65) zur Gewinnung von Zeitimpulsen (T), die die vorgegebenen Zeitpunkte (t, t + T) markieren, aus Ortsveränderungen einer vorgegebenen Länge, vorzugsweise gleich 1 m, der Station, wobei die Zeitimpulse auf die Schätzeinrichtungen (62) und die Reduktionseinrichtungen (63, 64, 21) gegeben werden, aufweist.

8. Einrichtung nach einem der Ansprüche 1 bis 7, dadurch gekennzeichnet, daß die Meßeinrichtungen Einrichtungen (1) zur Umsetzung eines hochfrequenten, von der Station empfangenen Signals in ein Signal mittlerer Frequenz (FI), Einrichtungen (5) zur Gewinnung eines Leistungssignals (pr), das proportional zur momentanen Leistung des Signals mittlerer Frequenz (FI) ist, und Einrichtungen (61) zur Bildung von Momentanwerten des Leistungssignals (pr) zu den vorgegebenen Zeitpunkten (t, t + T) als Proben der empfangenen Leistung $(pr^*_t)$, die in den Schätzeinrichtungen (62) verarbeitet werden, aufweisen.

9. Einrichtung nach Anspruch 8, dadurch gekennzeichnet, daß die Einrichtungen zur Gewinnung eines Leistungssignals (5) außerdem einen Spitzenwertdetektor (53) gefolgt von einem logarithmischen Verstärker (54) aufweisen.

10. Einrichtung nach einem der Ansprüche 1 bis 9, dadurch gekennzeichnet, daß die Reduktionseinrichtungen Verstärkungseinrichtungen (21) mit variablem Verstärkungsfaktor zur Verstärkung eines mit konstanter Leistung ($pe_M$) auszusendenden Signals und Einrichtungen (63, 64) zur Gewinnung eines Steuersignals für den Verstärkungsfaktor (G) der Verstärkungseinrichtungen aufweisen, wobei das Steuersignal des Verstärkungsfaktors in Dezibel nach einer linearen Funktion der geschätzten Leistung $(\widehat{pr}^*_{t+T})$ variiert.

11. Einrichtung nach einem der Ansprüche 1 bis 9, dadurch gekennzeichnet, daß die Reduktionseinrichtungen Einrichtungen (21) zur Dämpfung eines mit einer vorgegebenen Leistung ($pe_M$) auszusendenden Signals als Funktion einer variablen Dämpfung (A) unterhalb eines konstanten Verstärkungsfaktors ($G_{max}$), Einrichtungen

(21) zur Verstärkung des gedämpften auszusendenden Signals mit dem konstanten Verstärkungsfaktor ($G_{max}$), und Einrichtungen (63, 64), die die Dämpfungseinrichtungen zur Erzeugung einer variablen Dämpfung (A) als Funktion der Differenz der geschätzten Leistung ($\widehat{pr}^*_{t+T}$) und einer vorgegebenen Konstante ($p_m$ + MA) steuern, aufweisen.

12. Einrichtung nach Anspruch 11, dadurch gekennzeichnet, daß die vorgegebene Konstante von einer Empfangsempfindlichkeit ($p_m$) der Station und/oder von einer Spanne (MA) der Sendeleistung zum Schutz gegen Schwund abhängt.

13. Einrichtung nach Anspruch 11 oder 12, dadurch gekennzeichnet, daß die Einrichtungen zur Herstellung der variablen Dämpfung (63, 64) Einrichtungen (63) zur Herstellung einer Spannung, die nach einer unstetigen Treppenfunktion konstanter Stufenhöhe der geschätzten Leistung ($\widehat{pr}^*_{t+T}$) variiert, wobei jede Spannungsstufe zwischen zwei vorgegebenen, aufeinanderfolgenden Zeitpunkten erfaßt wird und proportional zur geschätzten Leistung ($\widehat{pr}^*_{t+T}$) am ersten der beiden Zeitpunkte ist, und Einrichtungen (64) zur Subtraktion einer zu der vorgegebenen Konstanten ($P_m$ + MA) proportionalen Spannung von jeder Spannungsstufe aufweisen.

FIG.1

# FIG. 2A

CONVERTISSEUR ANALOGIQUE-NUMERIQUE $62_E$

611 $\widehat{pr}_t^*$

625

SOUSTRACTEUR 621

MULTIPLICATEUR $k = 0,25$ (2 décalages) 622

ADDITIONNEUR 623

CIRCUIT DE RETARD T (Bascules) 624

CONVERTISSEUR NUMERIQUE-ANALOGIQUE $62_S$

631 $\widehat{pr}_{t+T}^*$

626

627

628

629

$\widehat{pr}_t^*$

62

# FIG. 2B

611 $pr_t^*$

625

621

$k$ 622

627

623

$\widehat{pr}_{t+T}^*$

631

626

628

$\widehat{pr}_t^*$

LIGNE DE RETARD 624

629

EP 0 239 467 B1

FIG.3

PUISSANCE (dBm)

CE(pe)

CR(pr)

NOMBRE DE MESURES

FIG.4A

PUISSANCE RECUE PAR LA STATION FIXE SANS CONTROLE DE PUISSANCE DANS LA STATION MOBILE

PUISSANCE (dBm)

puissance moyenne: -70,03dBm

NOMBRE DE MESURES

FIG.4B

PUISSANCE RECUE PAR LA STATION FIXE, AVEC CONTROLE DE PUISSANCE DANS LA STATION MOBILE

PUISSANCE (dBm)

puissance moyenne: -93,86dBm

NOMBRE DE MESURES